# EUROPEAN PATENT APPLICATION

(11) **EP 4 455 105 A1**
(43) Date of publication of application: **30.10.2024**
(21) Application number: 22910765.1
(22) Date of filing: 28.11.2022
(51) Int. Cl.: C03C 17/34, C23C 14/06, F24C 15/04, F24C 15/10

(54) **FILM-ATTACHED TRANSPARENT SUBSTRATE, TOP PLATE FOR COOKER, WINDOW GLASS FOR HEAT COOKER, AND COVER GLASS**

(30) Priority: 21.12.2021 JP 2021207259
(71) Applicant: Nippon Electric Glass Co., Ltd., Otsu-shi, Shiga 520-8639 (JP); Tohoku University, Sendai-shi, Miyagi 980-8577 (JP)
(72) Inventor: YAMAZAKI, Yusuke, Otsu-shi, Shiga 520-8639 (JP); IMURA, Masaaki, Otsu-shi, Shiga 520-8639 (JP); TAKAMURA, Hitoshi, Sendai-shi, Miyagi 980-8577 (JP); OIKAWA, Itaru, Sendai-shi, Miyagi 980-8577 (JP); ISHII, Akihiro, Sendai-shi, Miyagi 980-8577 (JP); YAMAGUCHI, Mina, Sendai-shi, Miyagi 980-8577 (JP)
(74) Representative: Tetzner, Michael
(86) International application number: PCT/JP2022/043701
(87) International publication number: WO 2023/120047

(57) **Abstract**

Provided is a film-attached transparent substrate which has excellent light absorption capacity, is neutral both in reflected color and transmitted color, is less likely to produce a color shift depending on the angle of light incidence, and has an insulation property. A film-attached transparent substrate 1 includes: a transparent substrate 2; and an antireflection film 3 provided on one principal surface 2a of the transparent substrate 2, wherein the antireflection film 3 is a multi-layer film including one or more high-refractive index films 5 having a relatively high refractive index and one or more low-refractive index films 4 having a relatively low refractive index, at least one of the one or more low-refractive index films 4 is a light-absorbing film, and the light-absorbing film includes a dielectric phase containing a material having a band gap of not less than 2.0 eV and not more than 2.7 eV and a metallic phase.

## Description

### [Technical Field]

The present invention relates to film-attached transparent substrates, cooker top plates in which the film-attached transparent substrates are used, heat cooker window glasses in which the film-attached transparent substrates are used, and cover glasses in which the film-attached transparent substrates are used.

### [Background Art]

Conventionally, a film-attached transparent substrate having light absorption capacity has been considered as a top plate for a cooker or a cover glass for a viewing display.

In the top plate for a cooker, a film-attached glass substrate is used in which a light blocking film is provided on the underside surface of a glass substrate in order to hide the internal structure of the cooker (see, for example, Patent Literature 1). In the cover glass for a viewing display, a film-attached glass substrate is used in which an antireflection film is provided on the top surface of a glass substrate (see, for example, Patent Literature 2) .

### [Citation List]

### [Patent Literature]

[PTL 1]
   JP-A-2014-215018
[PTL 2]
   JP-A-2018-115105

### [Summary of Invention]

### [Technical Problem]

As is common with such a top plate for a cooker as above, it is required to make various types of information clearly visible during turn-on of a light source and hide the internal structure of the cooker during turn-off of the light source. However, when a glass substrate colored with black is used as a top plate for a cooker, there arises a problem that various information is less visible during turn-on of the light source. Furthermore, when a black inorganic pigment layer is provided as in the top plate of Patent Literature 1, the top plate may not take on an achromatic black color during turn-off of the light source or may fail to fully hide the internal structure of the cooker depending on the angle from which it is viewed. Therefore, a film-attached transparent substrate is demanded which is neutral both in reflected color and transmitted color and less likely to produce a color shift depending on the angle of light incidence.

Meanwhile, in giving a touch panel function to a viewing display, such as a liquid crystal display, a transparent substrate to which an antireflection film with a high insulation property is attached is often required as a cover glass to be provided on the front of the display.

An object of the present invention is to provide: a film-attached transparent substrate which has excellent light absorption capacity, is neutral both in reflected color and transmitted color, is less likely to produce a color shift depending on the angle of light incidence, and has an insulation property; a cooker top plate in which the film-attached transparent substrate is used; a heat cooker window glass in which the film-attached transparent substrate is used; and a cover glass in which the film-attached transparent substrate is used.

### [Solution to Problem]

A film-attached transparent substrate according to the present invention has a feature of including: a transparent substrate; and an antireflection film provided on one principal surface of the transparent substrate, wherein the antireflection film is a multi-layer film including one or more high-refractive index films having a relatively high refractive index and one or more low-refractive index films having a relatively low refractive index, at least one of the one or more low-refractive index films is a light-absorbing film, and the light-absorbing film includes a dielectric phase containing a material having a band gap of not less than 2.0 eV and not more than 2.7 eV and a metallic phase.

In the present invention, a refractive index of the light-absorbing film at a wavelength of 550 nm is preferably not less than 1.0 and not more than 2.2.

In the present invention, at least one of the one or more high-refractive index films is preferably at least one selected from the group consisting of niobium oxide, silicon nitride, tantalum oxide, titanium oxide, zirconium oxide, hafnium oxide, and aluminum oxide.

In the present invention, in the multi-layer film, the one or more high-refractive index films and the one or more low-refractive index films are preferably alternately layered.

In the present invention, an outermost layer of the multi-layer film located on a side thereof opposite to the transparent substrate is preferably a film containing silicon oxide or silicon nitride.

In the present invention, the material having a band gap of not less than 2.0 eV and not more than 2.7 eV is preferably a metal oxide.

In the present invention, the antireflection film preferably has an electric resistance value of 10⁶ Ω or more.

In the present invention, when light is allowed to enter the film-attached transparent substrate through the antireflection film, the film-attached transparent substrate preferably exhibits a luminous reflectance of 2% or less.

In the present invention, when light is allowed to enter the film-attached transparent substrate through the transparent substrate, the film-attached transparent substrate preferably exhibits a luminous reflectance of 6% or less.

In the present invention, the film-attached transparent substrate preferably has a luminous transmittance of 75% or less.

In the present invention, regarding at least one of a luminous reflectance and a luminous transmittance of the film-attached transparent substrate, it is preferred that, at an angle of light incidence of 0°, an absolute a* value in a L*a*b* color system is 5 or less and an absolute b* value in the L*a*b* color system is 5 or less.

In the present invention, regarding at least one of a luminous reflectance and a luminous transmittance of the film-attached transparent substrate, an absolute value of a difference between an a* value at an angle of light incidence of 0° and an a* value at an angle of light incidence of 45° in a L*a*b* color system is preferably 5 or less and an absolute value of a difference between a b* value at an angle of light incidence of 0° and a b* value at an angle of light incidence of 45° in the L*a*b* color system is preferably 5 or less.

A top plate for a cooker according to the present invention has a feature of including the film-attached transparent substrate structured according to the present invention, wherein the transparent substrate has a cooking surface on which a cooking utensil is to be placed and an underside surface opposite to the cooking surface, and the antireflection film is disposed on the underside surface of the transparent substrate.

A window glass for a heat cooker according to the present invention is a window glass for use in a heat cooker and has a feature of including the film-attached transparent substrate structured according to the present invention, wherein the light-absorbing film is disposed on a principal surface of the transparent substrate located toward a heating device of the heat cooker.

A cover glass according to the present invention is a cover glass for use with a display and has a feature of including the film-attached transparent substrate structured according to the present invention, wherein the transparent substrate is a front substrate and the antireflection film is disposed on a principal surface of the transparent substrate located on an opposite side of the transparent substrate relative to a principal surface of the transparent substrate where the display is provided.

### [Advantageous Effects of Invention]

The present invention enables provision of: a film-attached transparent substrate which has excellent light absorption capacity, is neutral both in reflected color and transmitted color, is less likely to produce a color shift depending on the angle of light incidence, and has an insulation property; a cooker top plate in which the film-attached transparent substrate is used; a heat cooker window glass in which the film-attached transparent substrate is used; and a cover glass in which the film-attached transparent substrate is used.

### [Brief Description of Drawings]

[Fig. 1]

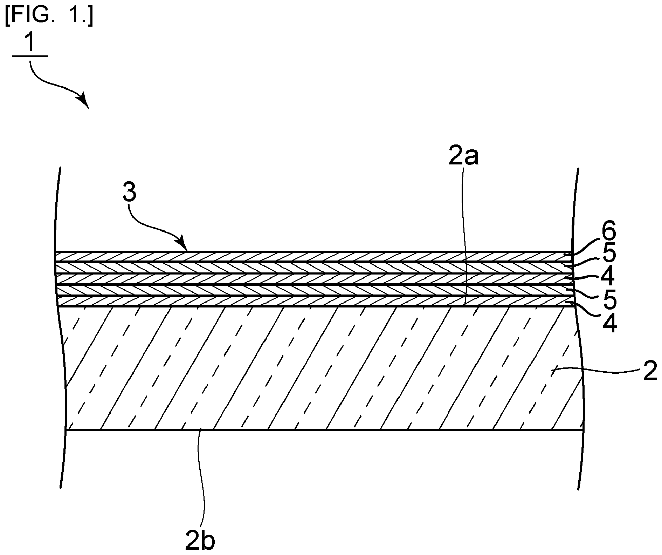

   Fig. 1 is a schematic cross-sectional view showing a film-attached transparent substrate according to a first embodiment of the present invention.
[Fig. 2]

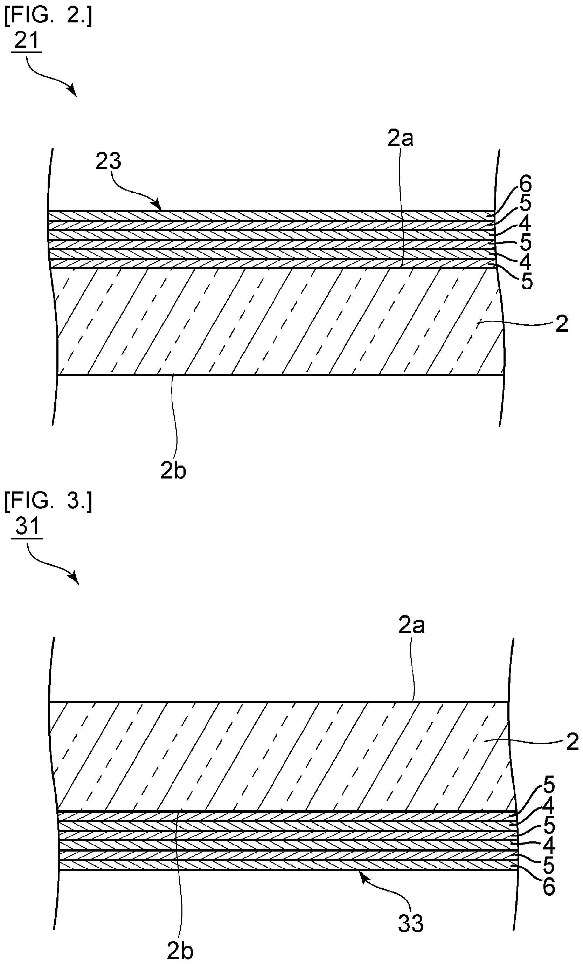

   Fig. 2 is a schematic cross-sectional view showing a film-attached transparent substrate according to a second embodiment of the present invention.
[Fig. 3]
   Fig. 3 is a schematic cross-sectional view showing a film-attached transparent substrate according to a third embodiment of the present invention.
[Fig. 4]

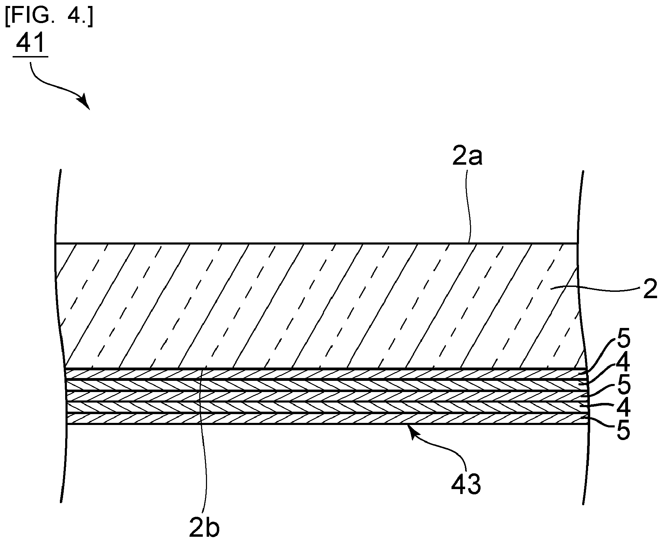

   Fig. 4 is a schematic cross-sectional view showing a film-attached transparent substrate according to a fourth embodiment of the present invention.
[Fig. 5]

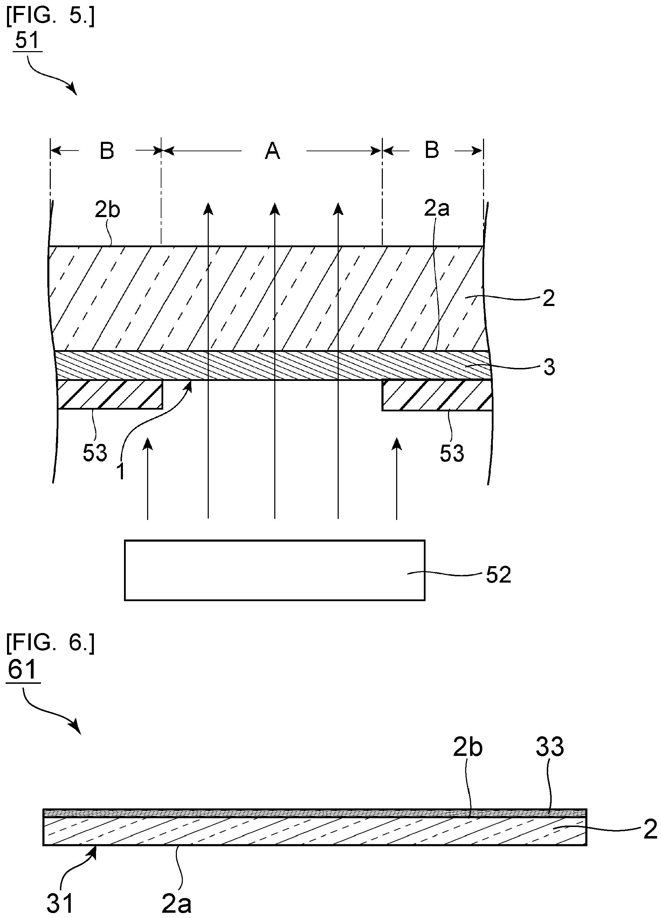

   Fig. 5 is a schematic cross-sectional view showing a top plate for a cooker according to an embodiment of the present invention.
[Fig. 6]
   Fig. 6 is a schematic cross-sectional view showing a cover glass according to an embodiment of the present invention.

### [Description of Embodiments]

Hereinafter, a description will be given of preferred embodiments. However, the following embodiments are merely illustrative and the present invention is not limited to the following embodiments. Throughout the drawings, members having substantially the same functions may be referred to by the same reference characters.

### [Film-Attached Transparent Substrate]

### (First Embodiment)

Fig. 1 is a schematic cross-sectional view showing a film-attached transparent substrate according to a first embodiment of the present invention. As shown in Fig. 1, a film-attached transparent substrate 1 includes a transparent substrate 2 and an antireflection film 3. The transparent substrate 2 has a first principal surface 2a and a second principal surface 2b opposed to each other. The antireflection film 3 is provided on the first principal surface 2a of the transparent substrate 2.

The antireflection film 3 is a multi-layer film including high-refractive index films 5 having a relatively high refractive index and low-refractive index films 4 having a relatively low refractive index. In this embodiment, the low-refractive index films 4 and the high-refractive index films 5 are alternately layered in a total of four layers beginning with the low-refractive index film 4 on the first principal surface 2a of the glass substrate 2. In addition, a silicon oxide film 6 is provided as an outermost layer on the high-refractive index film 5. Therefore, in this embodiment, the antireflection film 3 is formed of a five-layer multi-layer film. However, in the present invention, the number of layers of a multi-layer film constituting the antireflection film 3 is not particularly limited.

In this embodiment, both of the two low-refractive index films 4 are light-absorbing films. The light-absorbing film includes: a dielectric phase containing a material having a band gap of not less than 2.0 eV and not more than 2.7 eV; and a metallic phase. In the present invention, at least one of the low-refractive index films 4 is sufficient to be a light-absorbing film as just described.

Since the film-attached transparent substrate 1 according to this embodiment has the above-described structure, it has excellent light absorption capacity, is neutral both in reflected color and transmitted color, is less likely to produce a color shift depending on the angle of light incidence, and has an insulation property.

Since the film-attached transparent substrate 1 according to this embodiment has excellent light absorption capacity and is neutral both in reflected color and transmitted color, it can, for example, when used for a top plate for a cooker, take on an achromatic color, such as black, during turn-off of a light source and more certainly hide the internal structure of the cooker. Furthermore, since the film-attached transparent substrate 1 is less likely to produce a color shift depending on the angle of light incidence, it can hide the internal structure of the cooker regardless of the angle from which it is viewed, is less likely to cause a color change of the light source, and thus can ensure the viewability. In addition, for example, when used with a viewing display, such as a liquid crystal display, the film-attached transparent substrate 1 can improve the imaging quality or suppress degradation of the imaging quality, such as prevention of reflection of outside light and reduction in color change. Furthermore, the film-attached transparent substrate 1 has a high insulation property. Therefore, for example, when used with a viewing display, the film-attached transparent substrate 1 can be given a touch panel function.

Hereinafter, a description will be given in detail of the members of the film-attached transparent substrate 1.

### transparent Substrate>

The transparent substrate 2 has an approximately rectangular plate-like shape. However, the transparent substrate 2 may be approximately disc-shaped and the shape thereof is not particularly limited.

The transparent substrate 2 transmits light in a wavelength range of 400 nm to 700 nm. The transparent substrate 2 may be clear and colored, but is preferably clear and colorless from the viewpoint of further increasing the aesthetic appearance. Herein, "clear" means that the average light transmittance in a visible wavelength range from 400 nm to 700 nm is 80% or more. Furthermore, "colorless" means that the saturation of transmitted light upon application of light from a D65 light source is 2 or less.

In this embodiment, the transparent substrate 2 is made of a glass. However, the transparent substrate 2 may be made of another material, such as ceramics, so long as it is a transparent substrate.

The glass making up the transparent substrate 2 is preferably a glass having a high glass transition temperature and low expansibility or a low-expansion crystallized glass. Borosilicate glass, alkali-free glass, aluminosilicate glass or the like may be used as the transparent substrate 2. A specific example of the low-expansion crystallized glass is a LAS-based crystallized glass "N-0" manufactured by Nippon Electric Glass Co., Ltd. In these cases, the thermal resistance of the transparent substrate 2 can be further increased and the coefficient of thermal expansion thereof can be further lowered. Therefore, the transparent substrate 2 can be suitably used for a top plate for a cooker (hereinafter, also referred to simply as a "top plate") and so on undergoing repeated heating and cooling.

The thickness of the transparent substrate 2 is not particularly limited. The thickness of the transparent substrate 2 can be appropriately selected according to the light transmittance and so on. The thickness of the transparent substrate 2 may be, for example, about 0.035 mm to about 5 mm.

### <Antireflection Film>

The antireflection film 3 is a multi-layer film including high-refractive index films 5 having a relatively high refractive index and low-refractive index films 4 having a relatively low refractive index. The multi-layer film constituting the antireflection film 3 preferably includes, as in this embodiment, a section where the high-refractive index films 5 and the low-refractive index films 4 are alternately layered. In this case, the reflectance of the film-attached transparent substrate 1 can be further lowered.

### High-Refractive Index Film;

In this embodiment, the high-refractive index film 5 is a film made of niobium oxide and consisting primarily of niobium oxide. However, the high-refractive index film 5 may be a film consisting primarily of niobium oxide, silicon nitride, tantalum oxide, titanium oxide, zirconium oxide, hafnium oxide or aluminum oxide. These materials for the high-refractive index film 5 may be used singly or in combination of a plurality of them.

Herein, the "film consisting primarily of" means a film in which the relevant material is contained 50% by mass or more. In the film consisting primarily of the relevant material, the material is contained preferably 80% by mass or more and more preferably 90% by mass or more in the film. Naturally, the film consisting primarily of the relevant material may be a film in which the material is contained 100% by mass.

The thickness per layer of the high-refractive index films 5 is not particularly limited, but is preferably not less than 5 nm, more preferably not less than 10 nm, preferably not more than 400 nm, and more preferably not more than 250 nm. In this case, the reflectance of the film-attached transparent substrate 1 can be further lowered.

The number of layers of the high-refractive index films 5 in the antireflection film 3 is not particularly limited, but is preferably not less than 1, more preferably not less than 2, preferably not more than 10, and more preferably not more than 5. In this case, the reflectance of the film-attached transparent substrate 1 can be further lowered.

### Low-Refractive Index Film;

The low-refractive index film 4 is a light-absorbing film including: a dielectric phase containing a material having a band gap of not less than 2.0 eV and not more than 2.7 eV; and a metallic phase.

In the light-absorbing film, light absorption of the short wavelength side of visible light can be covered by light absorption due to the band gap of the dielectric phase and light absorption of the long wavelength side of visible light can be covered by light absorption due to free electrons of the metallic phase. Therefore, when the low-refractive index film 4 is a light-absorbing film, it can take on an achromatic color, such as, for example, black.

Furthermore, in this embodiment, the dielectric phase is a matrix and the metallic phase is dispersed in the matrix of the dielectric phase. In this case, the insulation property of the antireflection film 3 can be further increased. The metallic phase may be exposed at the surface of the dielectric phase. Alternatively, the light-absorbing film may be formed of a simple mixture of the dielectric phase and the metallic phase and the form of the mixture is not particularly limited. Elements of the metallic phase may be partly in contact with each other unless a conductive path of the metallic phase is formed throughout the light-absorbing film, and the elements of the metallic phase may not be of uniform size. These structures can be appropriately adjusted, for example, by the feed ratio of materials making up the dielectric phase and the metallic phase.

The dielectric phase is preferably made of a metal oxide having a band gap of not less than 2.0 eV and not more than 2.7 eV. Alternatively, the dielectric phase may be made of a metal oxynitride or metal nitride having a band gap of not less than 2.0 eV and not more than 2.7 eV. The band gap can be calculated, for example, from the Tauc plot.

Examples of the metal oxide having a band gap of not less than 2.0 eV and not more than 2.7 eV include Bi₂O₃ (2.5 eV), Fe₂O₃ (2.1 eV), Fe₃O₄ (2.0 eV), V₂O₅ (2.3 eV), WO₃ (2.5 eV), MoO₃ (2.7 eV), and Cr₂O₃ (2.6 eV) . Alternatively, the metal oxide may be a composite oxide, such as BiVO₄ (2.3 eV), containing cations of any of the above metal oxides. Examples of the metal oxynitride having a band gap of not less than 2.0 eV and not more than 2.7 eV include SrTaO₂N and TiO₂₋ₓNₓ (where x is, for example, 0.125).

The type of metal making up the metallic phase is not particularly limited and examples include Au, Ag, Cu, Pt, Pd, Rh, Zn, Fe, Sn, Ni, and Pb. The metallic phase may be made of an alloy of any of these metals. Examples of the alloy include FeNi and CuNi.

The volume ratio of the metallic phase in the light-absorbing film ((metallic phase)/(dielectric phase + metallic phase)) is preferably not less than 0.3, more preferably not less than 0.5, preferably not more than 0.8, and more preferably not more than 0.7. When the above volume ratio ((metallic phase)/(dielectric phase + metallic phase)) is the above lower limit or more, the insulation property of the light-absorbing film 3 can be further increased. Furthermore, when the above volume ratio ((metallic phase) / (dielectric phase + metallic phase)) is the above upper limit or less, a sufficient light absorption capacity can be more certainly achieved at wavelengths likely to cause optical interference.

The volume ratio of the dielectric phase in the light-absorbing film ((dielectric phase)/(dielectric phase + metallic phase)) is preferably not less than 0.2, more preferably not less than 0.3, preferably not more than 0.7, and more preferably not more than 0.5. When the above volume ratio ((dielectric phase) / (dielectric phase + metallic phase)) is the above lower limit or more, a sufficient light absorption capacity can be more certainly achieved at wavelengths likely to cause optical interference. When the above volume ratio ((dielectric phase)/(dielectric phase + metallic phase)) is the above upper limit or less, the insulation property of the light-absorbing film 3 can be further increased.

In the present invention, the content of material (metal) making up the metallic phase in the light-absorbing film (in 100% by mass) is preferably not less than 10% by mass, more preferably not less than 20% by mass, preferably not more than 90% by mass, and more preferably not more than 80% by mass. In this case, the light-absorbing film can absorb light more evenly over substantially the entire visible light range.

In the present invention, the content of material making up the dielectric phase in the light-absorbing film (in 100% by mass) is preferably not less than 10% by mass, more preferably not less than 20% by mass, preferably not more than 90% by mass, and more preferably not more than 80% by mass. In this case, the insulation property of the film-attached transparent substrate 1 can be further increased.

Examples of the preferred combination of the dielectric phase and the metallic phase include a combination in which the dielectric phase is iron oxide and the metallic phase is Ag, a combination in which the dielectric phase contains Al and Fe and the metallic phase is Ag, and a combination in which the dielectric phase contains Ag, Fe, and Cr and the metallic phase is Ag.

When the dielectric phase contains Al and Fe, the light-absorbing film preferably contains Ag, Al, and Fe to give a molar ratio Ag:Al:Fe = x:y:z (where x+y+z = 1, 0 < x < 1, 0 < y < 1, and 0 ≤ z < 1). In this case, the light-absorbing film can suppress color change due to heating and, therefore, can further increase the aesthetic appearance of the film-attached transparent substrate 1. The light-absorbing film may further contain 0.

When 0 < z < 1 in the above case, the light-absorbing film is a film containing Ag, aluminum oxide, and iron oxide. Alternatively, when z = 0, the light-absorbing film is a film containing Ag and aluminum oxide.

The light-absorbing film like the above can be deposited by sputtering or plused laser deposition (PLD), for example, using an Ag/Al/FeO mixed target. Alternatively, an Ag/FeO mixed target and an Al target may be separately used. Each target may not contain FeO.

When the dielectric phase contains Ag, Fe, and Cr, the light-absorbing film can suppress color change due to heating and, therefore, can further increase the aesthetic appearance of the film-attached transparent substrate 1. The light-absorbing film may further contain 0 in addition to Ag, Fe, and Cr.

The content of Ag in the light-absorbing film is preferably not less than 17% by mass, more preferably not less than 30% by mass, preferably not more than 65% by mass, and more preferably not more than 55% by mass. The content of Fe in the light-absorbing film is preferably not less than 25% by mass, more preferably not less than 32% by mass, preferably not more than 60% by mass, and more preferably not more than 50% by mass. The content of Cr in the light-absorbing film is preferably not less than 4% by mass, more preferably not less than 8% by mass, preferably not more than 17% by mass, and more preferably not more than 12% by mass. Herein, the content of each of the metals in the light-absorbing film is the content of the metal in the total content of metallic elements, excluding oxygen, in the light-absorbing film.

The mass ratio of Cr to Fe in the light-absorbing film (Cr/Fe) is preferably not less than 0.10, more preferably not less than 0.20, preferably not more than 0.60, and more preferably not more than 0.40. In this case, color change of the light-absorbing film due to heating can be made even less likely to occur.

The light-absorbing film may contain Ni, Mo, Cu, S, Mn, P, Si, and C which are components often contained in stainless steel. When the light-absorbing film contains Ni, the content of Ni is preferably not less than 3% by mass, more preferably not less than 6% by mass, preferably not more than 15% by mass, and more preferably not more than 12% by mass. The content of C in the light-absorbing film is preferably 1.2% by mass or less.

The light-absorbing film may further contain Al. In this case, color change of the light-absorbing film due to heating can be made even less likely to occur. The content of Al in the light-absorbing film is preferably not less than 2.5% by mass, more preferably not less than 5% by mass, preferably not more than 35% by mass, and more preferably not more than 30% by mass. However, from the viewpoint of giving greater importance to the absorption coefficient of the film, the light-absorbing film may not be substantially free of Al.

The contents of Ag, Fe, Ni, Cr, Al, and so on can be measured, for example, by energy dispersive X-ray analysis, wavelength-dispersive X-ray analysis or inductively coupled plasma mass spectrometry.

Furthermore, in the above case, the light-absorbing film is, specifically, a film containing Ag, iron oxide, and chromium oxide.

The light-absorbing film like the above can be deposited by sputtering or plused laser deposition (PLD), for example, using a mixed target of Ag and stainless steel. Alternatively, an Ag target and a stainless steel target may be separately used. Stainless steel refers to an alloy steel having a Fe content of 50% by mass or more, a Cr content of 10.5% by mass or more, and a C content of 1.2% by mass or less. Examples of stainless steel that can be used include SUS304, SUS301, and SUS316. When a stainless steel target is used, it has lower magnetic properties compared to a Fe target and, therefore, can stabilize discharging to provide a more stable film deposition. Particularly, when an austenite-based stainless steel target is used, it is non-magnetic (paramagnetic) and, therefore, can stabilize discharging to provide a particularly stable film deposition.

The thickness per layer of the light-absorbing films is not particularly limited, but is preferably not less than 5 nm, more preferably not less than 10 nm, preferably not more than 500 nm, and more preferably not more than 300 nm. In this case, the light absorption capacity of the film-attached transparent substrate 1 can be further increased and the insulation property thereof can be further increased.

The number of layers of light-absorbing films in the antireflection film 3 is not particularly limited, but is preferably not less than 1, more preferably not less than 2, preferably not more than 10, and more preferably not more than 5. In this case, the light absorption capacity of the film-attached transparent substrate 1 can be further increased and the insulation property thereof can be further increased.

The refractive index of the light-absorbing film at a wavelength of 550 nm is preferably not less than 1.0, more preferably not less than 1.2, preferably not more than 2.2, and more preferably not more than 2.0. In this case, the light absorption capacity of the film-attached transparent substrate 1 can be further increased and the insulation property thereof can be further increased. For the light-absorbing film, the magnitude of the refractive index can be adjusted by deposition conditions, such as, for example, the composition of the target or the deposition pressure.

The low-refractive index films 4 may include a low-refractive index film different from the light-absorbing film. Alternatively, all the low-refractive index films 4 may be each constituted by the light-absorbing film.

An example of the low-refractive index film different from the light-absorbing film is a film consisting primarily of silicon oxide, aluminum oxide, magnesium fluoride or barium fluoride.

The thickness per layer of the low-refractive index films 4 is not particularly limited, but is preferably not less than 5 nm, more preferably not less than 10 nm, preferably not more than 500 nm, and more preferably not more than 300 nm. In this case, the reflectance of the film-attached transparent substrate 1 can be further lowered.

The number of layers of the low-refractive index films 4 in the antireflection film 3 is not particularly limited, but is preferably not less than 1, more preferably not less than 2, preferably not more than 10, and more preferably not more than 5. In this case, the reflectance of the film-attached transparent substrate 1 can be further lowered.

### Outermost-Layer Film;

A silicon oxide film 6 can be provided as an outermost-layer film of the antireflection film 3. The silicon oxide film 6 is a film consisting primarily of silicon oxide. When the silicon oxide film 6 is provided as the outermost-layer film, the oxidation resistance, the sulfidation resistance, the weather resistance, and so on can be further increased. The same effects can also be obtained with the use of silicon nitride instead of silicon oxide. However, in the present invention, the silicon oxide film 6 or the silicon nitride film may not necessarily be provided.

The thickness per layer of the outermost-layer film is not particularly limited, but is preferably not less than 20 nm, more preferably not less than 50 nm, preferably not more than 500 nm, and more preferably not more than 300 nm.

### Antireflection Film;

The entire thickness of the antireflection film 3 is not particularly limited, but is preferably not less than 100 nm, more preferably not less than 200 nm, preferably not more than 1000 nm, and more preferably not more than 800 nm.

The number of layers of the multi-layer film constituting the antireflection film 3 is not particularly limited, but is preferably not less than 2, more preferably not less than 4, preferably not more than 20, and more preferably not more than 14.

The antireflection film 3 is preferably a dielectric multi-layer film having the above-described structure. In this case, when the film-attached transparent substrate 1 is used with a viewing display, changes in capacitance due to finger contact necessary for a capacitive touch sensor can be retained, which enables to make a touch panel operative. Therefore, the film-attached transparent substrate 1 can be more certainly given a touch panel function.

When the antireflection film 3 is a dielectric multi-layer film, the electric resistance value of the antireflection film 3 is preferably 10⁶ **Ω** (10⁶ **Ω**/sq) or more, more preferably 10⁷ **Ω** (10⁷ **Ω**/sq) or more, even more preferably 10⁸ **Ω** (10⁸ **Ω**/sq) or more, and particularly preferably 10⁹ **Ω** (10⁹ **Ω**/sq) or more. When the electric resistance value of the antireflection film 3 is the above lower limit or more, the film-attached transparent substrate 1 can be even more certainly given a touch panel function. The upper limit of the electric resistance value of the antireflection film 3 is, for example, 10¹¹ **Ω** (10¹¹ **Ω**/sq) . The electric resistance value can be measured by the method defined in ASTM D257, JIS K 6271-1 (2008), JIS K 6271-2 (2008), K 6911 (1995) or so on.

The method for forming the high-refractive index film 5, the low-refractive index film 4, and the silicon oxide film 6 which are constituents of the antireflection film 3 is not particularly limited and they can be formed, for example, by sputtering, plused laser deposition (PLD) or vapor deposition, which belong to the physical vapor deposition method (PVD method).

### <Film-Attached Transparent Substrate>

In the film-attached transparent substrate 1 according to this embodiment, light is allowed to enter it through the antireflection film 3. In doing so, the luminous reflectance of the film-attached transparent substrate 1 is preferably 2% or less, more preferably 1% or less, and even more preferably 0.7% or less. In this case, the reflectance of the film-attached transparent substrate 1 can be further lowered. The lower limit of the luminous reflectance of the film-attached transparent substrate 1 is not particularly limited, but may be, for example, 0.1%. When light is allowed to enter the film-attached transparent substrate 1 through the transparent substrate 2, the luminous reflectance of the film-attached transparent substrate 1 is preferably 6% or less. Also in this case, the lower limit of the luminous reflectance of the film-attached transparent substrate 1 is not particularly limited, but may be, for example, 0.1%.

The luminous transmittance of the film-attached transparent substrate 1 is preferably 75% or less, more preferably 70% or less, and even more preferably 65% or less. In this case, the light absorption capacity of the film-attached transparent substrate 1 can be further increased. The lower limit of the luminous transmittance of the film-attached transparent substrate 1 is not particularly limited, but may be, for example, 2%.

The luminous reflectance and the luminous transmittance can be determined, for example, by measuring the transmittance spectrum and the reflectance spectrum from the antireflection film 3 side with a spectro-photometer. In doing so, the angle of incidence (AOI) is set at 0°. The wavelength measurement range is set from 380 nm to 780 nm.

Regarding at least one of the luminous reflectance and the luminous transmittance of the film-attached transparent substrate 1, it is preferred that, at an angle of light incidence of 0°, the absolute a* value in the L*a*b* color system is 5 or less and the absolute b* value in the L*a*b* color system is 5 or less. In this case, the reflected color and the transmitted color of the film-attached transparent substrate 1 can be made more neutral.

The absolute a* value at an angle of light incidence of 0° is preferably 4 or less, and more preferably 2.5 or less. The lower limit of the absolute a* value is not particularly limited, but may be 0.

The absolute b* value at an angle of light incidence of 0° is preferably 4 or less, and more preferably 2.5 or less. The lower limit of the absolute b* value is not particularly limited, but may be 0.

Regarding at least one of the luminous reflectance and the luminous transmittance of the film-attached transparent substrate 1, the absolute L* value in the L*a*b* color system at an angle of light incidence of 0° is, for example, not less than 1 and not more than 20.

Regarding at least one of the luminous reflectance and the luminous transmittance of the film-attached transparent substrate 1, it is preferred that the absolute value of the difference between an a* value at an angle of light incidence of 0° and an a* value at an angle of light incidence of 45° in the L*a*b* color system is 5 or less and the absolute value of the difference between a b* value at an angle of light incidence of 0° and a b* value at an angle of light incidence of 45° in the L*a*b* color system is 5 or less. In this case, the production of a color shift depending on the angle of light incidence can be made less likely.

The absolute value of the difference between an a* value at an angle of light incidence of 0° and an a* value at an angle of light incidence of 45° is preferably 4 or less, and more preferably 2.5 or less. The lower limit of the absolute value of the difference between an a* value at an angle of light incidence of 0° and an a* value at an angle of light incidence of 45° is not particularly limited, but may be 0.

Furthermore, the absolute value of the difference between a b* value at an angle of light incidence of 0° and a b* value at an angle of light incidence of 45° is preferably 4 or less, and more preferably 2.5 or less. The lower limit of the absolute value of the difference between a b* value at an angle of light incidence of 0° and a b* value at an angle of light incidence of 45° is not particularly limited, but may be 0.

The above-mentioned L* value, a* value, and b* value can be determined, for example, in the following manner. First, the transmittance spectrum and the reflectance spectrum are measured from the antireflection film 3 side with a spectro-photometer. In doing so, the angle of incidence (AOI) is set at 0° and 45° and the wavelength measurement range is set from 380 nm to 780 nm. From the obtained transmittance spectrum and reflectance spectrum, the luminosities (L*) and chromaticities (a* and b*) of reflected light and transmitted light upon application of light from a D65 light source can be determined.

### (Second to Fourth Embodiments)

Fig. 2 is a schematic cross-sectional view showing a film-attached transparent substrate according to a second embodiment of the present invention. As shown in Fig. 2, in a film-attached transparent substrate 21, high-refractive index films 5 and low-refractive index films 4 are alternately layered in a total of five layers beginning with the high-refractive index film 5 on a first principal surface 2a of a glass substrate 2. In addition, a silicon oxide film 6 is provided as an outermost layer on the high-refractive index film 5. Thus, an antireflection film 23 is formed. The rest is the same as in the first embodiment.

As in the second embodiment, it may be layered beginning with the high-refractive index film 5 on a first principal surface 2a of a glass substrate 2. When a silicon oxide film 6 is provided as an outermost layer on the top of the high-refractive index film 5, the silicon oxide film 6 can serve also as a low-refractive index film 4.

Fig. 3 is a schematic cross-sectional view showing a film-attached transparent substrate according to a third embodiment of the present invention. As shown in Fig. 3, in a film-attached transparent substrate 31, high-refractive index films 5 and low-refractive index films 4 are alternately layered in a total of five layers beginning with the high-refractive index film 5 on a second principal surface 2b of a glass substrate 2. In addition, a silicon oxide film 6 is provided as an outermost layer on the high-refractive index film 5. Thus, an antireflection film 33 is formed. The rest is the same as in the first embodiment.

Fig. 4 is a schematic cross-sectional view showing a film-attached transparent substrate according to a fourth embodiment of the present invention. As shown in Fig. 4, in a film-attached transparent substrate 41, high-refractive index films 5 and low-refractive index films 4 are alternately layered in a total of five layers beginning with the high-refractive index film 5 on a second principal surface 2b of a glass substrate 2. Thus, an antireflection film 43 is formed. In the antireflection film 43, a silicon oxide film 6 is not provided as an outermost layer on the high-refractive index film 5. The rest is the same as in the first embodiment.

Whereas the antireflection film 3, 23 is provided on the first principal surface 2a of the transparent substrate 2 in the first and second embodiments, the antireflection film 33, 43 is provided on the second principal surface 2b of the transparent substrate 2 in the third and fourth embodiments.

Therefore, in the third and fourth embodiments, in measuring the luminous reflectance and luminous transmittance described in the first embodiment, the transmittance spectrum and the reflectance spectrum are measured from the first principal surface 2a side of the transparent substrate 2 (the opposite side to the antireflection film 33, 43).

When, as in the fourth embodiment, a silicon oxide film 6 is not provided as an outermost layer on the high-refractive index film 5, a silicon nitride film is preferably provided as an outermost high-refractive index film 5. In this case, the oxidation resistance, the sulfidation resistance, the weather resistance, and so on can be further increased.

Like the film-attached transparent substrate 1, the film-attached transparent substrates 21, 31, 41 according to the second to fourth embodiments have excellent light absorption capacity, are neutral both in reflected color and transmitted color, are less likely to produce a color shift depending on the angle of light incidence, and have an insulation property.

### [Top Plate for Cooker]

Fig. 5 is a schematic cross-sectional view showing a top plate for a cooker according to an embodiment of the present invention. As shown in Fig. 5, a top plate 51 for a cooker includes a film-attached transparent substrate 1.

In the top plate 51 for a cooker, a second principal surface 2b of a transparent substrate 2 being a constituent of the film-attached transparent substrate 1 is a cooking surface. On the other hand, a first principal surface 2a of the transparent substrate 2 being a constituent of the film-attached transparent substrate 1 is an underside surface. The cooking surface is a surface located on the side of the transparent substrate where a cooking utensil, such as a pot or a frying pan, is to be placed. The underside surface is a surface located on the side of the transparent substrate close to the interior of the cooker and facing a light source 52 for an LED, a display or so on and a heating device. Therefore, the cooking surface and the underside surface are top and under sides of the same substrate. In this embodiment, the transparent substrate 2 is made of a low-expansion crystallized glass.

An antireflection film 3 is provided on the underside surface (first principal surface 2a) of the transparent substrate 2. A heat-resistant resin layer 53 is provided on the antireflection film 3. The heat-resistant resin layer 53 may be provided between the transparent substrate 2 and the antireflection film 3. In this embodiment, a region where the heat-resistant resin layer 53 is not provided in plan view is a displaying region A. On the other hand, a region where the heat-resistant resin layer 53 is provided in plan view is a non-displaying region B.

The heat-resistant resin layer 53 is a light blocking layer. Therefore, when the heat-resistant resin layer 53 is provided, the hideability of the internal structure of the cooker can be more certainly increased. The heat-resistant resin layer 53 can be formed of a heat-resistant resin, such as silicone resin, a coloring pigment, and so on. However, the heat-resistant resin layer 53 may not necessarily be provided.

Below the film-attached transparent substrate 1, a light source 52 for a display, an LED or so on is provided. The light source 52 is a member provided for the purpose of displaying information in the displaying region A. The type of information to be displayed in the displaying region A is not particularly limited and examples include information indicating a state of the cooker, such as a power-on state or a heating state, and information on time and so on.

In the displaying region A, light from the light source 52 passes through the antireflection film 3 and the transparent substrate 2 in this order and is then emitted to the outside. On the other hand, in the non-displaying region B, the light from the light source 52 is blocked by the heat-resistant resin layer 53. Therefore, by transmitting the light from the light source 52 through the displaying region A, characters, numerals, signs, and so on can be displayed in the displaying region A.

The top plate 51 for a cooker includes the film-attached transparent substrate 1. Thus, the top plate 51 for a cooker can make the indication of various information clearly visible during turn-on of the light source 52 and have an excellent aesthetic appearance during turn-off of the light source 52. Furthermore, the boundary between the displaying region A and the non-displaying region B can be made less visible while the internal structure of the cooker is hidden. In addition, the internal structure of the cooker can be certainly hidden regardless of the angle from which the top plate 51 for a cooker is viewed. A display having a touch panel function may be contained in the interior of the cooker. In this case, a color change of the display is less likely to occur regardless of the angle of view and, therefore, the viewability can be ensured.

### [Window Glass for Heat Cooker]

Alternatively, the above-described top plate 51 for a cooker may be used as a heat cooker window glass for use in a heat cooker, such as a microwave or an oven. In this case, the second principal surface 2b of the transparent substrate 2 being a constituent of the above-described film-attached transparent substrate 1 can be used as a principal surface located on the side opposite to the heating device of the heat cooker, and the first principal surface 2a of the transparent substrate 2 being a constituent of the film-attached transparent substrate 1 can be used as a principal surface located toward the heating device of the heat cooker.

### [Cover Glass]

Fig. 6 is a schematic cross-sectional view showing a cover glass according to an embodiment of the present invention. As shown in Fig. 6, a cover glass 61 includes a film-attached transparent substrate 31. The cover glass 61 is, for example, a cover glass for use in a state where it is disposed on the front of a viewing display.

In the cover glass 61, a second principal surface 2b of a transparent substrate 2 being a constituent of the film-attached transparent substrate 31 is a principal surface disposed toward the outside. On the other hand, a first principal surface 2a of the transparent substrate 2 being a constituent of the film-attached transparent substrate 31 is a principal surface located toward the display. Therefore, in the cover glass 61, an antireflection film 33 is provided on the principal surface 2b of the transparent substrate 2 located on the opposite side thereof relative to the principal surface thereof where the display is provided.

The cover glass 61 includes the film-attached transparent substrate 31. Therefore, when used with a viewing display, such as a liquid crystal display, the cover glass 61 can improve the imaging quality, such as prevention of reflection of outside light. In addition, the cover glass 61 has a high insulation property. Therefore, when used with a viewing display, the cover glass 61 can be given a touch panel function.

Hereinafter, a description will be given in further detail of the present invention with reference to examples. However, the following examples are merely illustrative. The present invention is not at all limited by the following examples .

### (Examples 1 to 6)

A dielectric multi-layer film was made on a first principal surface of a glass substrate (trade name "OA-10G" manufactured by Nippon Electric Glass Co., Ltd., thickness: 0.5 mm, refractive index: 1.52) being a transparent substrate by sputtering. Specifically, an antireflection film was made on the glass substrate in a manner that a light-absorbing film (Ag-SUS-O, with a refractive index of 1.56 and an extinction coefficient of 1.21), a niobium oxide film (Nb₂O₅, with a refractive index of 2.29 and an extinction coefficient of 0), an Ag-SUS-O film, a Nb₂O₅ film, and a silicon oxide film (SiO₂ film, with a refractive index of 1.46 and an extinction coefficient of 0) were layered in this order on the glass substrate to give an associated structure and associated film thicknesses (thicknesses) shown in Table 1 below. Thus, a film-attached transparent substrate was produced. Herein, in Examples and Comparative Examples, all the refractive indices and the extinction coefficients are those at a wavelength of 550 nm. Furthermore, the electric resistance value of the antireflection film was measured by the two-terminal DC method using platinum electrodes.

The Ag-SUS-O film as a light-absorbing film was deposited by sputtering using a mixed target of Ag and stainless steel (SUS304) . The content of Ag and the content of stainless steel in the mixed target were 32.6% by mass and 67.4% by mass, respectively. During the deposition, the substrate temperature was 250°C and the oxygen partial pressure was 0.03 Pa. Regarding the contents of metallic elements, excluding oxygen, in the light-absorbing film, the content of Ag was 48.022% by mass, the content of Fe was 32.782% by mass, and the content of Cr was 10.615% by mass. Each of the compositions was measured by an electron probe microanalyzer (EPMA, stock number "JXA-8100" manufactured by JEOL) .

**[Table 1]**

| Ex. 1 | | | Ex. 2 | | | Ex. 3 | | |
|---|---|---|---|---|---|---|---|---|
| Material | Thickness (nm) | Electric Resistance (Ω) | Material | Thickness (nm) | Electric Resistance (Ω) | Material | Thickness (nm) | Electric Resistance (Ω) |
| SiO₂ | 87.5 | 3×10¹⁰ | SiO₂ | 64.5 | 4×10¹⁰ | SiO₂ | 69.2 | 6×10¹⁰ |
| Nb₂O₅ | 41.1 | | Nb₂O₅ | 11.4 | | Nb₂O₅ | 13.5 | |
| Ag-SUS-O | 15.0 | | Ag-SUS-O | 25.0 | | Ag-SUS-O | 15.0 | |
| Nb₂O₅ | 21.8 | | Nb₂O₅ | 25.9 | | Nb₂O₅ | 23.3 | |
| Ag-SUS-O | 6.0 | | Ag-SUS-O | 40.0 | | Ag-SUS-O | 69.7 | |
| Glass | | | Glass | | | Glass | | |
| | | | | | | | | |

| Ex. 4 | | | Ex. 5 | | | Ex. 6 | | |
|---|---|---|---|---|---|---|---|---|
| Material | Thickness (nm) | Electric Resistance (Ω) | Material | Thickness (nm) | Electric Resistance (Ω) | Material | Thickness (nm) | Electric Resistance (Ω) |
| SiO₂ | 64.5 | 8×10¹⁰ | SiO₂ | 54.0 | 8×10¹⁰ | SiO₂ | 57.7 | 9×10¹⁰ |
| Nb₂O₅ | 11.4 | | Nb₂O₅ | 14.6 | | Nb₂O₅ | 13.3 | |
| Ag-SUS-O | 25.0 | | Ag-SUS-O | 35.0 | | Ag-SUS-O | 35.0 | |
| Nb₂O₅ | 25.9 | | Nb₂O₅ | 24.7 | | Nb₂O₅ | 20.5 | |
| Ag-SUS-O | 40.0 | | Ag-SUS-O | 55.0 | | Ag-SUS-O | 100.0 | |
| Glass | | | Glass | | | Glass | | |

### (Examples 7 to 16 and Comparative Examples 1 and 2)

A film-attached transparent substrate was obtained in the same manner as in Example 1 except that an antireflection film was formed on a first principal surface of a glass substrate to give an associated structure and associated thicknesses (film thicknesses) shown in Tables 2 and 3 below. Tables 2 and 3 show that films were formed, beginning at the lowest, on the first principal surface of the glass substrate.

In Examples 7 to 9, silicon nitride films (SiN films, with a refractive index of 1.99 and an extinction coefficient of 0) were formed as high-refractive index films instead of Nb₂O₅ films. In Examples 10 to 12, Ag-Fe-O films (with a refractive index of 1.70 and an extinction coefficient of 1.39) were used as light-absorbing films instead of Ag-SUS-O films. In Examples 13 and 14, Ag-Fe-O films and SiN films were used. In Example 15, Ag-Al-Fe-O films (with a refractive index of 1.18 and an extinction coefficient of 1.49) were used as light-absorbing films instead of Ag-SUS-O films. In Example 16, Ag-Al-Fe-O films and SiN films were used. In Comparative Example 1, SiO₂ films and niobium nitride films (NbN, with a refractive index 2.96 and an extinction coefficient of 0.47) serving as light-absorbing films and also as conductors were used. In Comparative Example 2, a SiO₂ film and titanium nitride films (TiN, with a refractive index 1.20 and an extinction coefficient of 1.71) serving as light-absorbing films and also as conductors were used.

The Ag-Fe-O film as the light-absorbing film was deposited by sputtering using an Ag/FeO mixed target. The content of Ag in the mixed target was 32.6% by mass. During the deposition, the substrate temperature was 250°C and the oxygen partial pressure was 0.025 Pa. Regarding the contents of metallic elements, excluding oxygen, in the light-absorbing film, the content of Ag was 58.1% by mass and the content of Fe was 41.9% by mass.

The Ag-Al-Fe-O film as the light-absorbing film was deposited by sputtering using an Ag/Al/FeO mixed target. The content of Ag in the mixed target was 60% by mole. During the deposition, the substrate temperature was 300°C and the oxygen partial pressure was 0.5 Pa. Regarding the contents of metallic elements, excluding oxygen, in the light-absorbing film, the content of Ag was 88% by mole, the content of Fe was 10% by mole, and the content of Al was 2% by mole. The ratio of the content of Al to the total content of Al and Fe (y/ (y+z)) (Al/ (Al+Fe)) was 0.14 in terms of a molar ratio. The composition among Ag, Al, and Fe was measured by inductively coupled plasma mass spectrometry.

**[Table 2]**

| Ex. 7 | | | Ex. 8 | | | Ex. 9 | | |
|---|---|---|---|---|---|---|---|---|
| Material | Thickness (nm) | Electric Resistance (Ω) | Material | Thickness (nm) | Electric Resistance (0) | Material | Thickness (nm) | Electric Resistance (Ω) |
| SiO₂ | 67.5 | 5×10¹⁰ | SiO₂ | 60.9 | 5×10¹⁰ | SiO₂ | 59.5 | 6×10¹⁰ |
| SiN | 10.0 | | SiN | 10.0 | | SiN | 10.0 | |
| Ag-SUS-O | 16.7 | | Ag-SUS-O | 27.5 | | Ag-SUS-O | 29.9 | |
| SiN | 46.0 | | SiN | 37.1 | | SiN | 31.4 | |
| Ag-SUS-O | 25.0 | | Ag-SUS-O | 50.0 | | Ag-SUS-O | 75.0 | |
| SiN | 10.0 | | SiN | 10.0 | | SiN | 10.0 | |
| Glass | | | Glass | | | Glass | | |
| | | | | | | | | |

| Ex. 10 | | | Ex. 11 | | | Ex. 12 | | |
|---|---|---|---|---|---|---|---|---|
| Material | Thickness (nm) | Electric Resistance (Ω) | Material | Thickness (nm) | Electric Resistance (Ω) | Material | Thickness (nm) | Electric Resistance (Ω) |
| | | 4×10¹⁰ | | | 4×10¹⁰ | | | 2×10¹⁰ |
| | | | SiO₂ | 67.8 | | SiO₂ | 83.1 | |
| SiO₂ | 75.7 | | Nb₂O₅ | 9.5 | | Nb₂O₅ | 116.6 | |
| Ag-Fe-O | 6.0 | | Ag-Fe-O | 15.3 | | SiO₂ | 20.2 | |
| Nb₂O₅ | 29.2 | | Nb₂O₅ | 25.6 | | Nb₂O₅ | 44.6 | |
| Ag-Fe-O | 25.0 | | Ag-Fe-O | 35.0 | | Ag-Fe-O | 20.0 | |
| Glass | | | Glass | | | Glass | | |

**[Table 3]**

| Ex. 13 | | | Ex. 14 | | | Ex. 15 | | |
|---|---|---|---|---|---|---|---|---|
| Material | Thickness (nm) | Electric Resistance (Ω) | Material | Thickness (nm) | Electric Resistance (Ω) | Material | Thickness (nm) | Electric Resistance (Ω) |
| SiO₂ | 69.5 | 3×10¹⁰ | SiO₂ | 65.7 | 5×10¹⁰ | | | 2×10¹⁰ |
| SiN | 10.0 | | SiN | 10.0 | | | | |
| Ag-Fe-O | 12.8 | | Ag-Fe-O | 18.3 | | SiO₂ | 76.8 | |
| SiN | 48.2 | | SiN | 43.8 | | Ag-AI-Fe-O | 8.2 | |
| Ag-Fe-O | 20.0 | | Ag-Fe-O | 30.0 | | Nb₂O₅ | 25.5 | |
| SiN | 10.0 | | SiN | 10.0 | | Ag-AI-Fe-O | 15.0 | |
| Glass | | | Glass | | | Glass | | |
| | | | | | | | | |

| Ex. 16 | | | Comp. Ex. 1 | | | Comp. Ex. 2 | | |
|---|---|---|---|---|---|---|---|---|
| Material | Thickness (nm) | Electric Resistance (Ω) | Material | Thickness (nm) | Electric Resistance (Ω) | Material | Thickness (nm) | Electric Resistance (Ω) |
| SiO₂ | 70.3 | 2×10¹⁰ | | | 6×10³ | SiO₂ | 54.1 | 4×10³ |
| SiN | 7.0 | | | | | Nb₂O₅ | 15.0 | |
| Ag-AI-Fe-O | 10.0 | | SiO₂ | 77.4 | | TiN | 23.0 | |
| SiN | 51.2 | | NbN | 19.8 | | Nb₂O₅ | 36.7 | |
| Ag-AI-Fe-O | 15.0 | | SiO₂ | 21.7 | | TiN | 30.0 | |
| SiN | 22.1 | | NbN | 40.0 | | Nb₂O₅ | 10.6 | |
| Glass | | | Glass | | | Glass | | |

### [Evaluations]

The obtained film-attached transparent substrates were measured in terms of transmittance spectrum and reflectance spectrum from their deposited surface sides with a spectro-photometer (stock number "U-4100" manufactured by Hitachi High-Tech Science Corporation). Specifically, the angle of incidence (AOI) was set at 0°, 15°, 30°, and 45° and the wavelength measurement range was set from 380 nm to 780 nm. From the obtained transmittance spectra and reflectance spectra, the luminous reflectances, the luminous transmittances, the luminosities (L*) and chromaticities (a* and b*) of reflected light and transmitted light upon application of light from a D65 light source were determined. In each table, the luminous reflectance and the luminous transmittance are shown by Y. In the measurement of the luminous reflectance, the reflection at the underside surface of the glass substrate was excluded.

The results are shown in Tables 4 to 8 below.

**[Table 4]**

| Ex. 1 | | | | | | | | | Ex. 2 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L * | a* | b* | Y (%) | L * | a* | b* | | Y (%) | L* | a* | b* | Y (%) | L * | a* | b* |
| 0 | 0.32 | 2.90 | 0.21 | -0.19 | 61.68 | 82.74 | -0.24 | -2.72 | 0 | 0.20 | 1.82 | -0.11 | -0.49 | 51.12 | 76.75 | -0.08 | -1.46 |
| 15 | 0.34 | 3.07 | 0.90 | 0.79 | 61.32 | 82.55 | -0.25 | -2.59 | 15 | 0.23 | 2.10 | 0.13 | 0.17 | 50.78 | 76.55 | -0.07 | -1.35 |
| 30 | 0.52 | 4.73 | 2.68 | 3.32 | 60.18 | 81.93 | -0.25 | -2.24 | 30 | 0.43 | 3.85 | 1.36 | 1.55 | 49.73 | 75.91 | -0.05 | -1.03 |
| 45 | 1.35 | 11.62 | 4.41 | 4.94 | 57.90 | 80.68 | -0.23 | -1.65 | 45 | 1.29 | 11.24 | 3.92 | 3.73 | 47.76 | 74.67 | -0.11 | -0.54 |
| | | | | | | | | | | | | | | | | | |

| Ex. 3 | | | | | | | | | Ex. 4 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L * | a* | b* | Y (%) | L * | a* | b* | | Y (%) | L* | a* | b* | Y (%) | L * | a* | b* |
| 0 | 0.25 | 2.29 | -0.83 | 0.77 | 40.68 | 69.95 | 0.18 | -2.35 | 0 | 0.14 | 1.28 | -1.30 | 0.17 | 21.64 | 53.64 | 0.71 | -4.02 |
| 15 | 0.30 | 2.68 | -0.58 | 0.90 | 40.30 | 69.68 | 0.19 | -2.18 | 15 | 0.16 | 1.42 | -1.10 | 0.28 | 21.30 | 53.27 | 0.71 | -3.73 |
| 30 | 0.51 | 4.65 | 0.78 | 0.93 | 39.17 | 68.87 | 0.21 | -1.69 | 30 | 0.28 | 2.52 | 0.30 | 0.12 | 20.33 | 52.21 | 0.72 | -2.93 |
| 45 | 1.41 | 12.01 | 3.65 | 1.47 | 37.19 | 67.42 | 0.17 | -0.94 | 45 | 0.98 | 8.86 | 4.66 | 0.04 | 18.81 | 50.47 | 0.69 | -1.79 |

**[Table 5]**

| Ex. 5 | | | | | | | | | Ex. 6 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L * | a* | b* | Y (%) | L * | a* | b* | | Y (%) | L * | a* | b* | Y (%) | L* | a* | b* |
| 0 | 0.30 | 2.69 | -0.67 | -0.05 | 11.66 | 40.68 | 0.91 | -4.79 | 0 | 0.23 | 2.08 | -0.52 | -0.19 | 3.36 | 21.42 | 0.99 | -2.39 |
| 15 | 0.33 | 2.95 | -0.42 | -0.10 | 11.40 | 40.25 | 0.91 | -4.43 | 15 | 0.26 | 2.31 | -0.67 | 0.07 | 3.25 | 21.00 | 1.01 | -2.12 |
| 30 | 0.50 | 4.50 | 1.12 | -0.54 | 10.67 | 39.02 | 0.91 | -3.43 | 30 | 0.41 | 3.66 | -0.18 | 0.04 | 2.95 | 19.85 | 1.07 | -1.38 |
| 45 | 1.34 | 11.57 | 4.38 | -0.38 | 9.60 | 37.11 | 0.89 | -2.10 | 45 | 1.17 | 10.35 | 2.69 | -0.25 | 2.55 | 18.13 | 1.13 | -0.37 |
| | | | | | | | | | | | | | | | | | |

| Ex. 7 | | | | | | | | | Ex. 8 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L* | a* | b* | Y (%) | L * | a* | b* | | Y (%) | L * | a* | b* | Y (%) | L * | a* | b* |
| 0 | 0.27 | 2.46 | -0.73 | 2.75 | 36.73 | 67.07 | 0.06 | -4.24 | 0 | 0.22 | 2.01 | -1.40 | 1.04 | 15.26 | 45.98 | 0.65 | -5.22 |
| 15 | 0.31 | 2.77 | -0.79 | 3.19 | 36.37 | 66.80 | 0.07 | -4.01 | 15 | 0.24 | 2.17 | -1.40 | 1.24 | 14.96 | 45.58 | 0.66 | -4.83 |
| 30 | 0.48 | 4.38 | -0.35 | 3.95 | 35.30 | 65.98 | 0.10 | -3.33 | 30 | 0.37 | 3.32 | -0.44 | 1.05 | 14.14 | 44.44 | 0.66 | -3.78 |
| 45 | 1.27 | 11.07 | 2.01 | 4.30 | 33.42 | 64.50 | 0.11 | -2.34 | 45 | 1.08 | 9.62 | 3.42 | 0.22 | 12.90 | 42.61 | 0.65 | -2.34 |

**[Table 6]**

| Ex. 9 | | | | | | | | | Ex. 10 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L * | a* | b* | Y (%) | L * | a* | b* | | Y (%) | L* | a* | b* | Y (%) | L* | a* | b* |
| 0 | 0.22 | 1.95 | -1.31 | 1.28 | 7.35 | 32.59 | 0.82 | -3.57 | 0 | 0.12 | 1.06 | -1.68 | 0.02 | 40.59 | 69.88 | -1.14 | 1.27 |
| 15 | 0.23 | 2.08 | -1.36 | 1.50 | 7.16 | 32.16 | 0.84 | -3.23 | 15 | 0.13 | 1.14 | -1.48 | 0.07 | 40.33 | 69.70 | -1.13 | 1.35 |
| 30 | 0.35 | 3.14 | -0.54 | 1.32 | 6.64 | 30.97 | 0.88 | -2.31 | 30 | 0.25 | 2.26 | -0.42 | 0.16 | 39.55 | 69.15 | -1.10 | 1.56 |
| 45 | 1.05 | 9.38 | 3.23 | 0.51 | 5.89 | 29.14 | 0.92 | -1.07 | 45 | 1.01 | 9.07 | 2.75 | 1.96 | 38.06 | 68.06 | -1.12 | 1.86 |
| | | | | | | | | | | | | | | | | | |

| Ex. 11 | | | | | | | | | Ex. 12 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L* | a* | b* | Y (%) | L * | a* | b* | | Y (%) | L * | a* | b* | Y (%) | L * | a* | b* |
| 0 | 0.17 | 1.51 | -2.18 | 0.35 | 23.52 | 55.61 | -1.41 | 1.47 | 0 | 0.25 | 2.26 | -0.61 | 0.78 | 54.95 | 79.01 | -0.80 | 1.08 |
| 15 | 0.16 | 1.48 | -1.90 | -0.14 | 23.28 | 55.36 | -1.39 | 1.58 | 15 | 0.27 | 2.46 | -1.35 | 1.57 | 54.72 | 78.88 | -0.75 | 1.11 |
| 30 | 0.24 | 2.16 | -0.47 | -1.62 | 22.57 | 54.63 | -1.35 | 1.90 | 30 | 0.43 | 3.91 | -3.23 | 3.11 | 53.97 | 78.44 | -0.61 | 1.23 |
| 45 | 0.89 | 8.05 | 4.04 | -2.48 | 21.37 | 53.35 | -1.35 | 2.34 | 45 | 1.15 | 10.18 | -0.56 | 0.51 | 52.38 | 77.51 | -0.57 | 1.61 |

**[Table 7]**

| Ex. 13 | | | | | | | | | Ex. 14 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L* | a* | b* | Y (%) | L* | a* | b* | | Y (%) | L* | a* | b* | Y (%) | L* | a* | b* |
| 0 | 0.21 | 1.87 | -0.64 | 2.19 | 37.25 | 67.47 | -1.37 | 0.49 | 0 | 0.15 | 1.35 | -1.22 | 0.27 | 23.83 | 55.92 | -1.57 | 0.04 |
| 15 | 0.24 | 2.16 | -0.69 | 2.58 | 37.01 | 67.29 | -1.35 | 0.58 | 15 | 0.17 | 1.55 | -1.23 | 0.40 | 23.60 | 55.68 | -1.55 | 0.21 |
| 30 | 0.42 | 3.78 | -0.33 | 3.42 | 36.28 | 66.73 | -1.31 | 0.87 | 30 | 0.31 | 2.84 | -0.49 | 0.37 | 22.91 | 54.98 | -1.51 | 0.67 |
| 45 | 1.23 | 10.77 | 1.72 | 4.69 | 34.83 | 65.62 | -1.29 | 1.28 | 45 | 1.07 | 9.55 | 2.75 | 0.52 | 21.70 | 53.71 | -1.50 | 1.30 |
| | | | | | | | | | | | | | | | | | |

| Ex. 15 | | | | | | | | | Ex. 16 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L * | a* | b* | Y (%) | L* | a* | b* | | Y (%) | L* | a* | b* | Y (%) | L* | a* | b* |
| 0 | 0.26 | 2.32 | 0.43 | 1.94 | 58.23 | 80.87 | -2.45 | -4.61 | 0 | 0.27 | 2.47 | -0.22 | -0.09 | 58.01 | 80.74 | -2.82 | -4.80 |
| 15 | 0.31 | 2.82 | 0.52 | 2.03 | 57.84 | 80.65 | -2.44 | -4.39 | 15 | 0.30 | 2.73 | 0.03 | 0.49 | 57.60 | 80.51 | -2.81 | -4.54 |
| 30 | 0.57 | 5.11 | 1.50 | 2.00 | 56.63 | 79.97 | -2.42 | -3.75 | 30 | 0.47 | 4.27 | 1.21 | 1.90 | 56.33 | 79.80 | -2.80 | -34.82 |
| 45 | 1.54 | 12.88 | 3.56 | 2.79 | 54.31 | 78.64 | -2.45 | -2.86 | 45 | 1.25 | 10.94 | 4.02 | 4.19 | 53.90 | 78.40 | -2.82 | -2.75 |

**[Table 8]**

| Comp. Ex. 1 | | | | | | | | | Comp. Ex. 2 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L* | a* | b* | Y (%) | L* | a* | b* | | Y (%) | L* | a* | b* | Y (%) | L* | a* | b* |
| 0 | 0.82 | 7.40 | -2.47 | 0.34 | 40.40 | 69.75 | 4.37 | 30.41 | 0 | 0.14 | 1.29 | -1.00 | 0.58 | 41.25 | 70.35 | -2.17 | -4.95 |
| 15 | 0.76 | 6.89 | 0.66 | -0.88 | 40.49 | 69.81 | 4.21 | 30.43 | 15 | 0.14 | 1.28 | -0.87 | 0.13 | 40.88 | 70.09 | -2.13 | -4.70 |
| 30 | 0.79 | 7.09 | 10.10 | -2.69 | 40.59 | 69.89 | 3.71 | 30.34 | 30 | 0.22 | 2.00 | 0.32 | -1.41 | 39.78 | 69.31 | -2.05 | -4.00 |
| 45 | 1.67 | 13.68 | 15.00 | -0.64 | 40.07 | 69.52 | 2.90 | 29.74 | 45 | 0.88 | 7.98 | 5.16 | -2.31 | 37.82 | 67.88 | -2.03 | -3.00 |

### (Examples 17 to 25)

A film-attached transparent substrate was obtained in the same manner as in Examples 1 to 16 except that a dielectric multi-layer film was formed on a second principal surface of a glass substrate to give an associated structure and associated thicknesses (film thicknesses) shown in Tables 9 and 10 below. Tables 9 and 10 show that films were formed, beginning at the highest in the table, on the second principal surface of the glass substrate.

**[Table 9]**

| Ex. 17 | | | Ex. 18 | | | Ex. 19 | | |
|---|---|---|---|---|---|---|---|---|
| Material | Thickness (nm) | Electric Resistance (Ω) | Material | Thickness (nm) | Electric Resistance (Ω) | Material | Thickness (nm) | Electric Resistance (Ω) |
| Glass | | 5×10¹⁰ | Glass | | 7×10¹⁰ | Glass | | 8×10¹⁰ |
| Nb₂O₅ | 31.2 | | Nb₂O₅ | 26.7 | | Nb₂O₅ | 25.9 | |
| Ag-SUS-O | 35.5 | | Ag-SUS-O | 30.8 | | Ag-SUS-O | 34.2 | |
| Nb₂O₅ | 12.6 | | Nb₂O₅ | 27.6 | | Nb₂O₅ | 24.8 | |
| SiO₂ | 73.6 | | Ag-SUS-O | 25.0 | | Ag-SUS-O | 65.0 | |
| Nb₂O₅ | 127.8 | | Nb₂O₅ | 84.3 | | SiO₂ | 97.2 | |
| SiO₂ | 93.7 | | SiO₂ | 101.9 | | | | |
| | | | | | | | | |

| Ex. 20 | | | Ex. 21 | | | Ex. 22 | | |
|---|---|---|---|---|---|---|---|---|
| Material | Thickness (nm) | Electric Resistance (Ω) | Material | Thickness (nm) | Electric Resistance (Ω) | Material | Thickness (nm) | Electric Resistance (Ω) |
| Glass | | 8×10¹⁰ | Glass | | 7×10¹⁰ | Glass | | 2×10¹⁰ |
| Nb₂O₅ | 25.3 | | Nb₂O₅ | 30.7 | | Nb₂O₅ | 35.8 | |
| Ag-SUS-O | 33.6 | | Ag-Fe-O | 29.6 | | Ag-Al-Fe-O | 10.0 | |
| Nb₂O₅ | 22.4 | | Nb₂O₅ | 27.6 | | Nb₂O₅ | 51.7 | |
| Ag-SUS-O | 100.0 | | Ag-Fe-O | 75.0 | | Ag-Al-Fe-O | 9.5 | |
| SiO₂ | 25.0 | | SiO₂ | 25.0 | | SiO₂ | 71.9 | |
| | | | | | | | | |

**[Table 10]**

| Ex. 23 | | | Ex. 24 | | | Ex. 25 | | |
|---|---|---|---|---|---|---|---|---|
| Material | Thickness (nm) | Electric Resistance (Ω) | Material | Thickness (nm) | Electric Resistance (Ω) | Material | Thickness (nm) | Electric Resistance (Ω) |
| Glass | | 8×10¹⁰ | Glass | | 7×10¹⁰ | Glass | | 3×10¹⁰ |
| SiN | 37.2 | | SiN | 43.0 | | SiN | 39.8 | |
| Ag-SUS-O | 29.6 | | Ag-Fe-O | 24.2 | | Ag-Al-Fe-O | 7.0 | |
| SiN | 29.9 | | SiN | 36.3 | | SiN | 92.8 | |
| Ag-SUS-O | 95.0 | | Ag-Fe-O | 80.0 | | Ag-Al-Fe-O | 15.6 | |
| SiN | 36.0 | | SiN | 25.0 | | SiN | 19.1 | |
| | | | | | | | | |

### [Evaluations]

The obtained film-attached transparent substrates were measured in terms of transmittance spectrum and reflectance spectrum from their principal surfaces sides of the glass substrates opposite to their deposited surfaces with a spectro-photometer (stock number "U-4100" manufactured by Hitachi High-Tech Science Corporation). Specifically, the angle of incidence (AOI) was set at 0°, 15°, 30°, and 45° and the wavelength measurement range was set from 380 nm to 780 nm. From the obtained transmittance spectra and reflectance spectra, the luminous reflectances, the luminous transmittances, the luminosities (L*) and chromaticities (a* and b*) of reflected light and transmitted light upon application of light from a D65 light source were determined. In each table, the luminous reflectance and the luminous transmittance are shown by Y.

The results are shown in Tables 11 to 13 below.

**[Table 11]**

| Ex. 17 | | | | | | | | | Ex. 18 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L* | a* | b* | Y (%) | L* | a* | b* | | Y (%) | L* | a* | b* | Y (%) | L* | a* | b* |
| 0 | 4.60 | 25.57 | 1.87 | -0.66 | 41.29 | 70.38 | -1.64 | -2.09 | 0 | 4.54 | 25.38 | 1.29 | -1.18 | 27.71 | 59.62 | 0.64 | -1.62 |
| 15 | 4.58 | 25.50 | 2.04 | -1.06 | 40.77 | 70.01 | -0.88 | -2.10 | 15 | 4.55 | 25.40 | 1.45 | -1.28 | 27.39 | 59.33 | 0.35 | -1.41 |
| 30 | 4.73 | 25.95 | 2.46 | -2.03 | 39.43 | 69.06 | 1.27 | -1.82 | 30 | 4.70 | 25.86 | 1.97 | -1.68 | 26.39 | 58.40 | -0.41 | -1.03 |
| 45 | 5.85 | 29.02 | 2.43 | -3.06 | 37.62 | 67.74 | 3.79 | -0.17 | 45 | 5.65 | 28.51 | 2.50 | -1.84 | 24.53 | 56.62 | -1.34 | -1.03 |
| | | | | | | | | | | | | | | | | | |

| Ex. 19 | | | | | | | | | Ex. 20 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L* | a* | b* | Y (%) | L* | a* | b* | | Y (%) | L* | a* | b* | Y (%) | L* | a* | b* |
| 0 | 4.36 | 24.84 | 0.03 | -0.57 | 9.19 | 36.34 | 1.33 | -1.40 | 0 | 4.37 | 24.87 | 0.34 | -1.10 | 3.52 | 22.02 | 0.72 | -3.55 |
| 15 | 4.37 | 24.86 | 0.18 | -0.64 | 9.02 | 36.02 | 1.31 | -1.09 | 15 | 4.38 | 24.88 | 0.52 | -1.19 | 3.40 | 21.57 | 0.73 | -3.24 |
| 30 | 4.53 | 25.34 | 0.66 | -0.88 | 8.55 | 35.10 | 1.25 | -0.26 | 30 | 4.53 | 25.36 | 1.05 | -1.44 | 3.07 | 20.31 | 0.77 | -2.41 |
| 45 | 5.48 | 28.05 | 1.32 | -1.19 | 7.85 | 33.67 | 1.14 | 0.84 | 45 | 5.47 | 28.04 | 1.65 | -1.57 | 2.59 | 18.33 | 0.85 | -1.35 |

**[Table 12]**

| Ex. 21 | | | | | | | | | Ex. 22 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L * | a* | b* | Y (%) | L * | a* | b* | | Y (%) | L * | a* | b* | Y (%) | L* | a* | b* |
| 0 | 4.43 | 25.05 | -0.22 | -0.60 | 4.58 | 25.49 | -2.29 | -1.10 | 0 | 4.83 | 26.25 | 0.46 | -0.85 | 68.45 | 86.23 | -2.06 | -4.89 |
| 15 | 4.44 | 25.07 | -0.03 | -0.65 | 4.46 | 25.13 | -2.26 | -0.91 | 15 | 4.83 | 26.24 | 1.11 | -0.96 | 68.04 | 86.02 | -2.16 | -4.55 |
| 30 | 4.58 | 25.52 | 0.56 | -0.80 | 4.12 | 24.07 | -2.16 | -0.40 | 30 | 5.00 | 26.73 | 2.98 | -1.18 | 66.71 | 85.36 | -2.45 | -3.66 |
| 45 | 5.50 | 28.12 | 1.35 | -0.93 | 3.62 | 22.37 | -2.01 | 0.27 | 45 | 6.17 | 29.84 | 4.98 | -0.90 | 63.99 | 83.96 | -2.93 | -2.50 |
| | | | | | | | | | | | | | | | | | |

| Ex. 23 | | | | | | | | | Ex. 24 | | | | | | | | |
|---|---|---|---|---|---|---|---|---|---|---|---|---|---|---|---|---|---|
| AOI (°) | Luminous Reflectance | | | | Luminous Transmittance | | | | AOI (°) | Luminous Reflectance | | | | Luminous Transmittance | | | |
| | Y (%) | L * | a* | b* | Y (%) | L * | a* | b* | | Y (%) | L * | a* | b* | Y (%) | L * | a* | b* |
| 0 | 4.34 | 24.76 | 0.13 | -0.37 | 4.72 | 25.93 | 0.44 | -0.48 | 0 | 4.57 | 25.47 | 0.51 | -0.27 | 4.75 | 26.02 | -2.53 | 0.20 |
| 15 | 4.36 | 24.81 | 0.20 | -0.27 | 4.58 | 25.51 | 0.47 | -0.27 | 15 | 4.57 | 25.48 | 0.62 | -0.13 | 4.63 | 25.66 | -2.48 | 0.35 |
| 30 | 4.54 | 25.39 | 0.46 | -0.10 | 4.19 | 24.30 | 0.56 | 0.28 | 30 | 4.72 | 25.91 | 0.97 | 0.13 | 4.29 | 24.62 | -2.33 | 0.72 |
| 45 | 5.53 | 28.20 | 0.86 | -0.03 | 3.64 | 22.46 | 0.62 | 0.98 | 45 | 5.62 | 28.43 | 1.46 | 0.28 | 3.78 | 22.93 | -2.15 | 1.16 |

**[Table 13]**

| Ex. 25 | | | | | | | | |
|---|---|---|---|---|---|---|---|---|
| AOI (°) | Luminous Reflectance | | | | Luminous Transmittance | | | |
| | Y (%) | L * | a* | b* | Y (%) | L * | a* | b* |
| 0 | 4.45 | 25.11 | 0.78 | -1.15 | 57.00 | 80.18 | -2.74 | -4.57 |
| 15 | 4.45 | 25.11 | 1.11 | -1.16 | 56.67 | 79.99 | -2.79 | -4.22 |
| 30 | 4.64 | 25.69 | 1.99 | -1.38 | 55.54 | 79.35 | -2.91 | -3.21 |
| 45 | 5.86 | 29.05 | 2.84 | -1.97 | 53.04 | 77.90 | -3.02 | -2.56 |

As seen from the above, the film-attached transparent substrates in Examples 1 to 25 were confirmed to have a low reflectance and a light absorption property (a transmittance of 75% or less), be neutral both in reflected color and transmitted color at an angle of light incidence of 0° (regarding at least one of the luminous reflectance and the luminous transmittance, |a* | ≤ 5 and |b*| ≤ 5), be able to be given a touch panel function (electric resistance ≥ 10⁶ Ω), and be less likely to produce a color shift at angles of incidence of 0° and 45° (regarding at least one of the luminous reflectance and the luminous transmittance, |a*| ≤ 5 and |b*| ≤ 5).

### [Reference Signs List]

1, 21, 31, 41 ... film-attached transparent substrate
2 ... transparent substrate
2a ... first principal surface
2b ... second principal surface
3, 23, 33, 43 ... antireflection film
4 ... low-refractive index film
5 ... high-refractive index film
6 ... silicon oxide film
51 ... top plate for cooker
52 ... light source
53 ... heat-resistant resin layer
61 ... cover glass

## Claims

1. A film-attached transparent substrate comprising:
a transparent substrate; and
an antireflection film provided on one principal surface of the transparent substrate,
wherein the antireflection film is a multi-layer film including one or more high-refractive index films having a relatively high refractive index and one or more low-refractive index films having a relatively low refractive index,
at least one of the one or more low-refractive index films is a light-absorbing film, and
the light-absorbing film includes a dielectric phase containing a material having a band gap of not less than 2.0 eV and not more than 2.7 eV and a metallic phase.

2. The film-attached transparent substrate according to claim 1, wherein a refractive index of the light-absorbing film at a wavelength of 550 nm is not less than 1.0 and not more than 2.2.

3. The film-attached transparent substrate according to claim 1 or 2, wherein at least one of the one or more high-refractive index films is at least one selected from the group consisting of niobium oxide, silicon nitride, tantalum oxide, titanium oxide, zirconium oxide, hafnium oxide, and aluminum oxide.

4. The film-attached transparent substrate according to any one of claims 1 to 3, wherein, in the multi-layer film, the one or more high-refractive index films and the one or more low-refractive index films are alternately layered.

5. The film-attached transparent substrate according to any one of claims 1 to 4, wherein an outermost layer of the multi-layer film located on a side thereof opposite to the transparent substrate is a film containing silicon oxide or silicon nitride.

6. The film-attached transparent substrate according to any one of claims 1 to 5, wherein the material having a band gap of not less than 2.0 eV and not more than 2.7 eV is a metal oxide.

7. The film-attached transparent substrate according to any one of claims 1 to 6, wherein the antireflection film has an electric resistance value of 10⁶ Ω or more.

8. The film-attached transparent substrate according to any one of claims 1 to 7, wherein when light is allowed to enter the film-attached transparent substrate through the antireflection film, the film-attached transparent substrate exhibits a luminous reflectance of 2% or less.

9. The film-attached transparent substrate according to any one of claims 1 to 8, wherein when light is allowed to enter the film-attached transparent substrate through the transparent substrate, the film-attached transparent substrate exhibits a luminous reflectance of 6% or less.

10. The film-attached transparent substrate according to any one of claims 1 to 9, having a luminous transmittance of 75% or less.

11. The film-attached transparent substrate according to any one of claims 1 to 10, wherein, regarding at least one of a luminous reflectance and a luminous transmittance of the film-attached transparent substrate, an absolute a* value in a L*a*b* color system at an angle of light incidence of 0° is 5 or less and an absolute b* value in the L*a*b* color system at an angle of light incidence of 0° is 5 or less.

12. The film-attached transparent substrate according to any one of claims 1 to 11, wherein, regarding at least one of a luminous reflectance and a luminous transmittance of the film-attached transparent substrate, an absolute value of a difference between an a* value at an angle of light incidence of 0° and an a* value at an angle of light incidence of 45° in a L*a*b* color system is 5 or less and an absolute value of a difference between a b* value at an angle of light incidence of 0° and a b* value at an angle of light incidence of 45° in the L*a*b* color system is 5 or less.

13. A top plate for a cooker, the top plate comprising the film-attached transparent substrate according to any one of claims 1 to 12, wherein
the transparent substrate has a cooking surface on which a cooking utensil is to be placed and an underside surface opposite to the cooking surface, and
the antireflection film is disposed on the underside surface of the transparent substrate.

14. A window glass for use in a heat cooker, the window glass comprising the film-attached transparent substrate according to any one of claims 1 to 12, wherein the light-absorbing film is disposed on a principal surface of the transparent substrate located toward a heating device of the heat cooker.

15. A cover glass for use with a display, the cover glass comprising the film-attached transparent substrate according to any one of claims 1 to 12, wherein
the transparent substrate is a front substrate, and
the antireflection film is disposed on a principal surface of the transparent substrate located on an opposite side of the transparent substrate relative to a principal surface of the transparent substrate where the display is provided.
